# EUROPEAN PATENT SPECIFICATION

(11) **EP 4 242 936 B1**
(45) Date of publication and mention of the grant of the patent: **28.10.2026**
(21) Application number: 23159587.7
(22) Date of filing: 02.03.2023
(51) Int. Cl.: G06N 10/60

(54) **REDUCING RESOURCES IN QUANTUM CIRCUITS**
RESSOURCENREDUKTION IN QUANTENSCHALTUNGEN
RÉDUCTION DE RESSOURCES DANS DES CIRCUITS QUANTIQUES

(30) Priority: 08.03.2022 US 202217653949
(43) Date of publication of application: 13.09.2023
(73) Proprietor: The Boeing Company, Arlington, VA 22202 (US)
(72) Inventor: Nguyen, Nam Hoang, Chicago, IL 60606-1596 (US); Thompson, Richard Joel, Chicago, IL 60606-1596 (US); Lowell, John R., Chicago, IL 60606-1596 (US); Kagele, Marna M., Chicago, IL 60606-1596 (US); Williams, Kristen Smith, Chicago, IL 60606-1596 (US)
(74) Representative: Hoffmann Eitle

(56) References cited:
- HO LUN TANG ET AL: "qubit-ADAPT-VQE: An adaptive algorithm for constructing hardware-efficient ansatze on a quantum processor", ARXIV.ORG, CORNELL UNIVERSITY LIBRARY, 201 OLIN LIBRARY CORNELL UNIVERSITY ITHACA, NY 14853, 22 November 2019 (2019-11-22), XP081538354
- FAN YI ET AL: "Circuit-Depth Reduction of Unitary-Coupled-Cluster Ansatz by Energy Sorting", 29 June 2021 (2021-06-29), pages 1 - 10, XP093062385, Retrieved from the Internet <URL:https://arxiv.org/pdf/2106.15210v1.pdf> [retrieved on 20230710]
- YU ZHANG ET AL: "Variational Quantum Eigensolver with Reduced Circuit Complexity", ARXIV.ORG, CORNELL UNIVERSITY LIBRARY, 201 OLIN LIBRARY CORNELL UNIVERSITY ITHACA, NY 14853, 14 June 2021 (2021-06-14), XP081989544
- GUSHU LI ET AL: "Paulihedral: A Generalized Block-Wise Compiler Optimization Framework For Quantum Simulation Kernels", ARXIV.ORG, CORNELL UNIVERSITY LIBRARY, 201 OLIN LIBRARY CORNELL UNIVERSITY ITHACA, NY 14853, 7 September 2021 (2021-09-07), XP091051480
- SHI-XIN ZHANG ET AL: "Differentiable Quantum Architecture Search", ARXIV.ORG, CORNELL UNIVERSITY LIBRARY, 201 OLIN LIBRARY CORNELL UNIVERSITY ITHACA, NY 14853, 14 October 2021 (2021-10-14), XP091063033

## Description

### BACKGROUND INFORMATION

### 1. Field:

The present disclosure relates generally to computing system, more specifically, to an automated method for designing optimal program and circuits.

### 2. Background:

Advanced algorithm development can be difficult and time consuming. Particularly in the case of quantum computers, quantum algorithm development may also be counterintuitive due to dependence on quantum-mechanical behavior such as quantum entanglement and superposition. At present, the primary solution to algorithm development is to manually design a program or circuit, which might be performed on a classical simulation tool or directly on hardware, either classical or quantum.

HO LUN TANG ET AL: "qubit-ADAPT-VQE: An adaptive algorithm for constructing hardware-efficient ansatze on a quantum processor", ARXIV.ORG, CORNELL UNIVERSITY LIBRARY, 201 OLIN LIBRARY CORNELL UNIVERSITY ITHACA, NY 14853, 22 November 2019 relates to an adaptive algorithm for constructing hardware-efficient ansätze on a quantum processor, and discloses, as a result, that the additional measurement overhead of qubit-ADAPT compared to fixed-ansatz variational algorithms scales only linearly with the number of qubits.

Fan Yi ET AL: "Circuit-Depth Reduction of Unitary-Coupled-Cluster Ansatz by Energy Sorting", 29 June 2021 studies how the circuit depth of the unitary coupled cluster ansatz in the algorithm of variational quantum eigensolver can be significantly reduced by an energy-sorting strategy.

YU ZHANG ET AL: "Variational Quantum Eigensolver with Reduced Circuit Complexity", ARXIV.ORG, CORNELL UNIVERSITY LIBRARY, 201 OLIN LIBRARY CORNELL UNIVERSITY ITHACA, NY 14853, 14 June 2021 discloses an approach to reduce quantum circuit complexity in VQE for electronic structure calculations. Their algorithm, called ClusterVQE, splits the initial qubit space into subspaces (qubit clusters) which are further distributed on individual (shallower) quantum circuits.

GUSHU LI ET AL: "Paulihedral: A Generalized Block-Wise Compiler Optimization Framework For Quantum Simulation Kernels", ARXIV.ORG, CORNELL UNIVERSITY LIBRARY, 201 OLIN LIBRARY CORNELL UNIVERSITY ITHACA, NY 14853, 7 September 2021 discloses a Paulihedral which is a block-wise compiler framework that can optimize the subroutine of a quantum simulation kernel appearing as a very long gate sequence in many quantum programs by exploiting high-level program structure and optimization opportunities.

Therefore, it would be desirable to have a method and apparatus that take into account at least some of the issues discussed above, as well as other possible issues.

### SUMMARY

The invention is defined by the appended independent claims. Embodiments of the invention are defined in the appended dependent claims.

### BRIEF DESCRIPTION OF THE DRAWINGS

The illustrative embodiments, however, as well as a preferred mode of use, further objectives and features thereof, will best be understood by reference to the following detailed description of an illustrative embodiment of the present disclosure when read in conjunction with the accompanying drawings, wherein:
**Figure** 1 depicts a hardware efficient parameterized quantum circuit designed through trial and error in accordance with the prior art;
**Figure** 2 depicts a block diagram illustrating a quantum circuit modeling system in accordance with an illustrative embodiment;
**Figure** 3 depicts a variational quantum eigensolver process flow in accordance with an illustrative embodiment;
**Figure** 4 depicts four example Pauli strings that can be used to construct a quantum circuit in accordance with an illustrative embodiment;
**Figure 5A** depicts an example quantum circuit diagram illustrating a first layer of a parameterized quantum circuit in accordance with an illustrative embodiment;
**Figure** 5B depicts the addition of a second layer to the parameterized quantum circuit in **Figure** 5A in accordance with an illustrative embodiment;
**Figure** 6 depicts another example quantum circuit diagram illustrating the first two layers of a parameterized quantum circuit in accordance with an illustrative embodiment;
**Figure** 7 depicts a quantum circuit diagram illustrating a transpiled circuit based on the quantum circuit in **Figure** 6 in accordance with an illustrative embodiment;
**Figure** 8 depicts a flow diagram illustrating a process of minimizing a cost function of a quantum computation in accordance with an illustrative embodiment;
**Figure** 9 depicts a flow diagram illustrating a process flow for the VQE algorithm in accordance with an illustrative embodiment; and
**Figure 10** depicts a block diagram of a data processing system in accordance with an illustrative embodiment.

### DETAILED DESCRIPTION

The illustrative embodiments recognize and take into account one or more different considerations. The illustrative embodiments recognize and take into account that quantum computing potential speedups over classical ways of solving complex problems. Quantum computers are likely to provide enormous computing advantages for specific tasks such as materials modeling, optimization, machine learning, and cryptography.

The illustrative embodiments also recognize and take into account that current quantum processors are noisy with limited quantum resources (limited number of qubit and coherence time). Hence they are usually referred to as Noisy Intermediate-Scale Quantum (NISQ) devices. For this very reason, hybrid quantum-classical algorithms have become the prominent user for current hardware as they require less quantum resource than traditional quantum algorithms. In particular, the class of variational quantum algorithm (VQA), which includes the variational Quantum Eigensolver (VQE) algorithm and the Quantum approximate optimization algorithm (QAOA), is becoming very popular because they allow quantum speedup to difficult problems.

The illustrative embodiments also recognize and take into account that one of the key ingredients to success for these types of algorithms is the construction of the parameterized quantum circuit, also known as the ansatz (trial wave function). The more expressibility the parameterized quantum circuit possesses (i.e., the circuit's ability to generate quantum states) the greater likelihood of finding the correct solution. However, parameterized quantum circuits with arbitrary high expressibility have bad scaling in the number of parameters with respect to the dimension of the problem, making it undesirable and difficult to optimize over the VQA cost function landscape. Moreover, such parameterized quantum circuits often lead to a suboptimal solution simply because of the increase in the complexity of the search space.

The illustrative embodiments also recognize and take into account that there is no general rule of how to construct a parameterized quantum circuit with high enough expressibility to achieve an answer with high precision but also low in quantum resources.

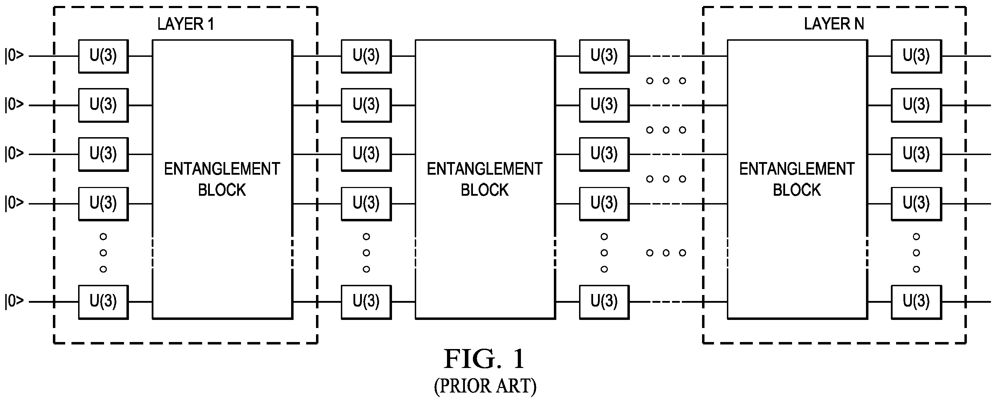

**Figure** 1 depicts a hardware efficient parameterized quantum circuit designed through trial and error in accordance with the prior art. Currently, giving the problem of interest, the parameterized quantum circuit is designed as multi-layered parameterized quantum circuits, in which layers of a circuit template are repeated with the goal of increasing the expressibility of the circuit. The number of repeated layers is chosen by trial and error. In the present example, the popular hardware efficient parameterized quantum circuit has the general form as shown in **Figure 1****.** This type of parameterized quantum circuit design can lead to a very long quantum circuit before it is expressible enough to represent the ground state wave function due to its fixed underlying structure.

The molecular electronic eigenvalue problem, which is about finding the electronic ground state energy of a molecular system under Born-Oppenheimer approximation, by itself, is a problem of great interest due to its ability to accurately model real molecules from first principles. However, because of the exponential scaling of the problem, it is impossible to find an exact solution of systems with more than a few dozen electrons on a classical computer. There are several approximation techniques that have been introduced to access large-scale systems with more than 1000 electrons on high-performance computers. However, these techniques do not provide solutions with chemical accuracy. Therefore, it is an infeasible task to deal with molecular structures with a few thousand electrons, even with the world's best supercomputer. Near-term quantum computers can potentially solve this problem efficiently using VQE. However, VQE is a heuristic algorithm, and its success depends heavily on the design of the parameterized quantum circuit.

The illustrative embodiments provide a method to determine a parameterized quantum circuit with just high enough expressibility with respect to the problem of interest while keeping the quantum resources as low as possible. The illustrative embodiments provide the ability to create a compact parameterized quantum circuit with low enough quantum resources to fit within NISQ devices while still achieving high precision results.

The illustrative embodiments apply to variational quantum algorithms such as the variational quantum eigensolver (VQE) algorithm. This approach enables reduction of quantum resources in a quantum circuit in comparison to increasing circuit expressibility by repeatedly adding the same circuit structure over and over again, as for example in the hardware efficient parameterized quantum circuit shown in **Figure 1****.**

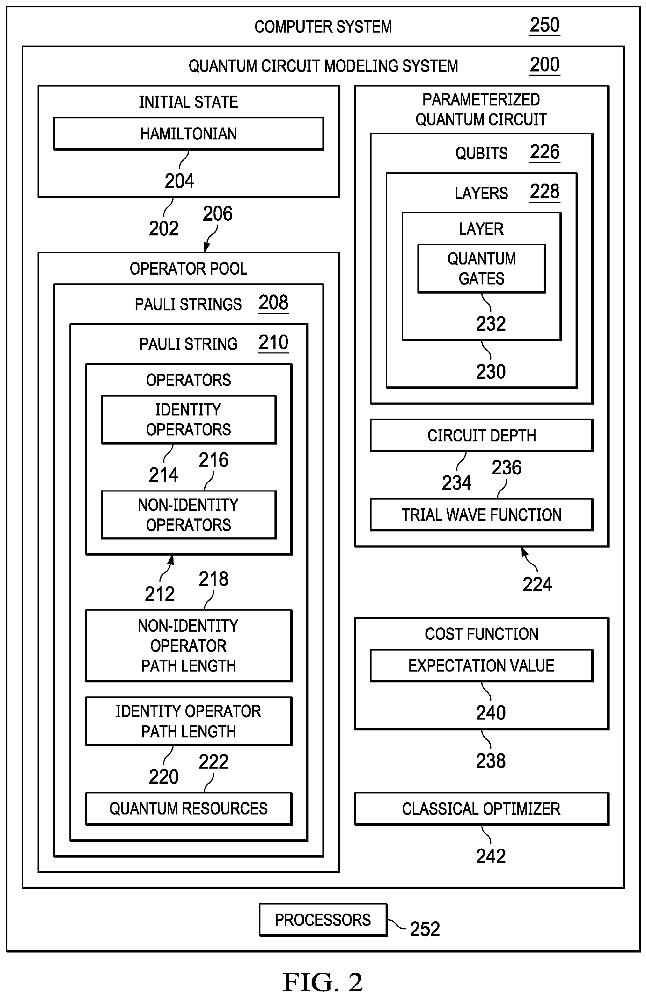

Turning now to **Figure 2****,** an illustration of a block diagram of a quantum circuit modeling system is depicted in accordance with an illustrative embodiment. Quantum circuit modeling system **200** generates and fine tunes parameterized quantum circuit **224** in order generate the ground state wave function to a chemical system. Quantum circuit modeling system **200** progressively fine tunes parameterized quantum circuit **224** until it generates a wave function with the lowest energy (ground state wave function).

Quantum circuit modeling system **200** begins by defining a mean-field initial state **202,** i.e., Hartree-Fock state, of the chemical system in question, which is characterized by Hamiltonian **204.**

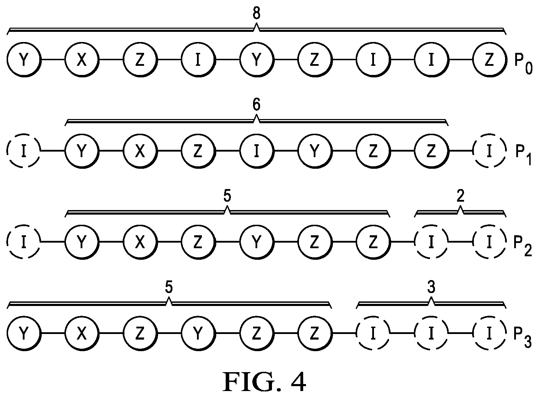

Hamiltonian **204** can be decomposed into a number of Pauli strings **208.** Each Pauli string **210** comprises a sequence of operators **212** that are made from Pauli matrices and the 2x2 Identity matrix, which defines a basis for the Hamiltonian **204.** Operators **212** may be divided into identity operators **214** and non-identity operators **216.** The sequence of operators **212** can be characterized by a non-identity operator path length **218** and an identity operator path length **220.** The non-identity operator path length **218** is the length of the Pauli string **210** (total number of operators) minus any exterior identity operators. For example, Pauli string YXZIYZIIZ has a non-identity operator path length of eight (the whole string), whereas Pauli string YXZXXXIII has a non-identity operator path length of five (see also **Figure 4****).** This number may comprise only a subset of the total number of operators **212** in the Pauli string **210** or the full number of operators **212** depending on the position of the identity operators **214** within the Pauli string. The shorter the non-identity operator path length **218,** the less quantum resources **222** associated with implementing the Pauli string **210** in parameterized quantum circuit **224.** The identity operator path length **220** is defined by the number of exterior identity operators **214** within the Pauli string **210.**

Parameterized quantum circuit **224** may comprise a number of layers **228** building from the exponentiation of Pauli strings. Each layer **230** has a corresponding Pauli string **210** which is selected based on its contribution to energy lowering (reducing the cost function value) as well as its structure, i.e., the identity and non-identity path length. Each layer **230** can be thought of as a sub-circuit in the form of quantum gates **232** applied to qubits **226** within the parameterized quantum circuit **224** according to the non-identity operators within a Pauli string. Circuit depth **234** is determined by the number of quantum gates **232** used in the longest path of the parameterized quantum circuit **224,** which determines the required coherence time, a quantum resource, for the parameterized quantum circuit **224.** For example, a quantum circuit using 10 qubits and having a depth of 20 consumes more quantum resources than a 10-quubit quantum circuit with a depth of five.

Parameterized quantum circuit **224** generates a trial wavefunction **236,** which is used to calculate an expectation value (energy) **240** for a cost function **238** associated with Hamiltonian **204** of the chemical system. The cost function **238** defines the energy landscape with respect to a particular parameterized quantum circuit, usually represented as: $C \left(θ\right) = \left〈ψ\left(θ\right)\right| H \left|ψ\left(θ\right)\right〉$

where *θ* represents the parameter vector that defines the parameterized quantum circuit **224,** i.e., *θ* = {*θ*₁,*θ*₂,···,*θₙ*}.

Many parameterized quantum circuits require a long circuit depth before they are able to generate the correct solution (wave function) sought. The illustrative embodiments allow for the design of a parameterized quantum circuit **224** that minimizes the circuit depth **234** while still generating the correct solution.

Classical optimizer **242** is used as part of the VQE algorithm to optimize the parameters in the parameterized quantum circuit **224** so that the cost function is minimize and to determine whether or not to continue adding more Pauli strings (layers **228)** to the parameterized quantum circuit **224.** Only those Pauli strings that contribute to lowering the cost function **238** are added to parameterized quantum circuit **224.** For example, the current parameterized quantum circuit may be in the form: $U \left(θ\right) = {e}^{{iθ}_{1} {P}_{1}} {e}^{{iθ}_{2} {P}_{2}} ⋯ {e}^{{iθ}_{10} {P}_{10}}$ meaning it is formed by 10 Pauli strings *P*₁, *P*₂,··· *P*₁₀. The VQE algorithm may produce an energy of, e.g., -5. This value is compared to the VQE result with just 8 and 9 Pauli strings. If the energy values are essentially the same, no more Pauli strings (layers) would be added to the parameterized circuit **224.** However, if the energy is lower (over a predefined threshold) with 10 Pauli strings than with 9 Pauli strings, then another Pauli string would be added.

Quantum circuit modeling system **200** can be implemented in software, hardware, firmware, or a combination thereof. When software is used, the operations performed by quantum circuit modeling system **200** can be implemented in program code configured to run on hardware, such as a processor unit. When firmware is used, the operations performed by Quantum circuit modeling system **200** can be implemented in program code and data and stored in persistent memory to run on a processor unit. When hardware is employed, the hardware may include circuits that operate to perform the operations in quantum circuit modeling system **200.**

In the illustrative examples, the hardware may take a form selected from at least one of a circuit system, an integrated circuit, an application specific integrated circuit (ASIC), a programmable logic device, or some other suitable type of hardware configured to perform a number of operations. With a programmable logic device, the device can be configured to perform the number of operations. The device can be reconfigured at a later time or can be permanently configured to perform the number of operations. Programmable logic devices include, for example, a programmable logic array, a programmable array logic, a field programmable logic array, a field programmable gate array, and other suitable hardware devices. Additionally, the processes can be implemented in organic components integrated with inorganic components and can be comprised entirely of organic components excluding a human being. For example, the processes can be implemented as circuits in organic semiconductors.

These components for quantum circuit modeling system 200 can be located in computer system **250,** which is a physical hardware system and includes one or more data processing systems. When more than one data processing system is present in computer system **250,** those data processing systems are in communication with each other using a communications medium. The communications medium can be a network. The data processing systems can be selected from at least one of a computer, a server computer, a tablet computer, or some other suitable data processing system.

For example, quantum circuit modeling system **200** can run on one or more processors **252** in computer system **250.** As used herein a processor is a hardware device and is comprised of hardware circuits such as those on an integrated circuit that respond and process instructions and program code that operate a computer. When processors **252** execute instructions for a process, one or more processors can be on the same computer or on different computers in computer system **250.** In other words, the process can be distributed between processors **252** on the same or different computers in computer system **250.** Further, one or more processors **252** can be of the same type or different type of processors **252.** For example, one or more processors **252** can be selected from at least one of a single core processor, a dual-core processor, a multi-processor core, a general-purpose central processing unit (CPU), a graphics processing unit (GPU), a quantum processing unit (QPU), a digital signal processor (DSP), or some other type of processor.

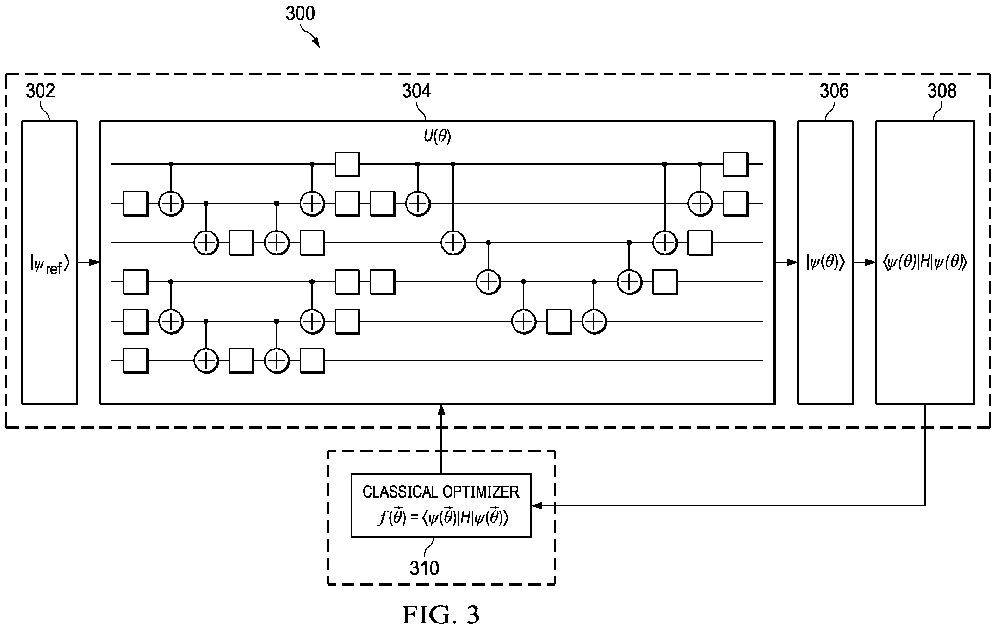

**Figure 3** depicts a variational quantum eigensolver (VQE) process flow in accordance with an illustrative embodiment. Search algorithm **300** can be implemented in quantum circuit modeling system **200** in **Figure 2****.**

Search algorithm **300** comprises three steps: 1) preparing an initial state **302,** 2) calculating the expectation value **308** for the Hamiltonian with a parameterized quantum circuit **304** that generates a trial wavefunction **306,** and 3) utilizing a classical optimizer **310** to minimize the cost function 〈(ψ(θ)|H|ψ(θ)〉 via updating the parameterized quantum circuit parameters *θ* in the quantum circuit. H describe the molecular electronic Hamiltonian within the Born-Oppenheimer approximation, which allows H to be written in the form of second quantization as: ${H}_{2 nd quant} = {\sum }_{pq} {h}_{pq} {a}_{p}^{†} {a}_{q} + {\sum }_{pqrs} {h}_{pqrs} {a}_{p}^{†} {a}_{q}^{†} {a}_{r} {a}_{s}$ which then can be mapped onto qubit operators using some type of transformations, like Jordan-Wigner or Bravyi-Kitaev, to arrive at the form: $H = {\sum }_{iα} {h}_{α}^{i} {σ}_{α}^{i} + {\sum }_{ijαβ} {h}_{αβ}^{ij} {σ}_{α}^{i} {σ}_{β}^{j} + {\sum }_{ijkαβ γ} {h}_{αβ γ}^{ijk} {σ}_{α}^{i} {σ}_{β}^{j} {σ}_{γ}^{k} + ⋯$

Using the linearity property of Trace produces: $\left〈ψ\left(θ\right)\right| H \left|ψ\left(θ\right)\right〉 = \left〈H\right〉 = {\sum }_{iα} {h}_{α}^{i} \left({σ}_{α}^{i}\right) + {\sum }_{ijαβ} {h}_{αβ}^{ij} \left〈{σ}_{α}^{i}{σ}_{β}^{j}\right〉 + {\sum }_{ijkαβ γ} {h}_{αβ γ}^{ijk} \left〈{σ}_{α}^{i}{σ}_{β}^{j}{σ}_{γ}^{k}\right〉 + ⋯$ which allows calculation of (H) on a current and near-term quantum computer. Furthermore, the terms in H only grow in the scale of O(N⁴) .

One of the advantages of executing variational type calculations on a quantum computer is the efficiency of generating hard trial wave functions on the quantum computer. There are states that can be prepared very efficiently on quantum computers but not on classical computers.

A key element of search algorithm **300** is designing a parameterized quantum circuit **304** that can efficiently generate a trial wavefunction **306** that is close to the ground state wavefunction, which allows a good approximation to the ground state energy.

Search algorithm **300** decomposes the molecular Hamiltonian into Pauli strings which are N-fold tensor products of Pauli matrices along with a 2x2 identity matrix. The number of Pauli strings will scale as O(N⁴) : $H = {\sum }_{iα} {h}_{α}^{i} {σ}_{α}^{i} + {\sum }_{ijαβ} {h}_{αβ}^{ij} {σ}_{α}^{i} {σ}_{β}^{j} + {\sum }_{ijkαβ γ} {h}_{αβ γ}^{ijk} {σ}_{α}^{i} {σ}_{β}^{j} {σ}_{γ}^{k} + ⋯ = \sum {p}_{i} {P}_{i}$

The set containing all the relevant Pauli strings *Pᵢ* that will be used by this embodiment to construct an efficient parameterized quantum circuit will be denoted as *S*. It should be noted that *S* is constructed based on the Pauli strings in the Hamiltonian, *H*. However, the elements of *S* are not the same as the elements of *H.* The Pauli strings in *S* form an operator pool which are used to build the adaptive parameterized quantum circuit of the form: $U = {\prod }_{i = depth} {e}^{- {γ}_{i} B} {e}^{- {iβ}_{i} {P}_{i}}$ wherein B can be taken to be *B =* Σ*ⱼ* ⊗*Xⱼ* or Σ*ⱼ* ⊗*Yⱼ* or Σ*ⱼ* ⊗*Iⱼ,* which is equivalent to just a layer of single qubit rotational gates *Rₓ*(*γⱼ*),*R_{Y}*(*γⱼ*) or identity gates, respectively. It can take the form of some other single qubit rotations as well as a mixture of different single qubit rotations, e.g., a mixture of *R_{Y} and R_{X}* rotations. Ideally, it is desirable for *B* and *Pᵢ* to not commute, as commuting operators share a common eigenvector.

After the set, *S*, of Pauli strings is determined, the illustrative embodiments construct the parameterized quantum circuit, *U*, layer by layer until convergence is reached, meaning there is no further reduction in energy, i.e., the cost function has reached its minimum value. Once a Pauli string is added to the parameterized quantum circuit, that string is removed from set, *S*, so is it no longer in the pool of operators available to add to the parameterized quantum circuit in future iterations.

Building the first layer of the parameterized quantum circuit comprises finding a *Pₖ* ∈ *S* such that: $\left〈ψ\right| ref {e}^{i {γ}_{k} B} {e}^{i {β}_{k} {P}_{k}} H {e}^{- i {γ}_{k} B} {e}^{- i {β}_{k} {P}_{k}} {\left|ψ\right〉}_{ref} \leq \left〈ψ\right| ref {e}^{i {γ}_{k} B} {e}^{i {β}_{k} {P}_{i}} H {e}^{- i {γ}_{k} B} {e}^{- i {β}_{k} {P}_{i}} {\left|ψ\right〉}_{ref} ∀ {P}_{i} ∈ S$

The search for this *Pₖ* is efficient. If VQE is chosen as an algorithm to determine *Pₖ* then |*S*| executions of VQE would be needed, which in the worst-case scales as *O*(*N*⁴). In general, it would be much less. It should be noted that the entire algorithm, from start to finish, will also scale as O(poly(N)). There might exist multiple *Pi* such that: $\left|\left〈ψ\right| ref{e}^{i {γ}_{k} B}{e}^{i {β}_{k} {P}_{k}}H{e}^{- i {γ}_{k} B}{e}^{- i {β}_{k} {P}_{k}}{\left|ψ\right〉}_{ref}{-}_{ref}\left〈ψ\right|{e}^{i {γ}_{k} B}{e}^{i {β}_{k} {P}_{i}}H{e}^{- i {γ}_{k} B}{e}^{- i {β}_{k} {P}_{i}}{\left|ψ\right〉}_{ref}\right| \leq ϵ$

Where $ϵ ∈ ℝ$ is any arbitrary value but should be taken to be the chemical precision threshold (10⁻³ Hartree) or smaller. Such Pᵢ belongs in a set that is denoted as M. Within M, we can determine its best element, ${P}_{optimal}^{1}$, based on the arrangement of the Pauli operators. This selection is based on the quantum resource needed to generate the circuit *Uᵢ = e^{-iβPᵢ} .* One of the criteria for choosing *Pᵢ* is the number of identity operators it contains. This criterion can be demonstrated with a simple example with *P* = *IX,* in which ${e}^{iβIX} = cos \left(β\right) IX + sin \left(β\right) IX = I \left(cos\left(β\right)X+sin\left(β\right)X\right)$ which is a circuit that involves only a single qubit. Therefore, the more identity operators, the better.

However, most current quantum processors do not have all-to-all qubit connections, but rather only neighboring qubit connection. Therefore, having more identity operators does not necessarily correspond to a less quantum resource, but rather having a certain arrangement of identity operators will reduce the circuit depth.

**Figure 4** depicts four example Pauli strings that can be used to construct a quantum circuit in accordance with an illustrative embodiment. The Pauli strings can be thought of as sub-circuits that search algorithm **300** can use as building blocks to build a parameterized quantum circuit **304**.

In this example, each Pauli string, P₀, P₁, P₂, P₃ includes three identity operators, I, but their corresponding circuits have different levels of complexity due to the respective sequences of their operators, specifically the positions of the identity operators.

In the present example, P₀ has the highest cost and complexity to implement, P₁ has the second highest cost, followed by P₂, and then P₃. The cost/complexity of a Pauli string and its associated quantum circuit is determined by the path length, which is defined by the length of the Pauli string minus any exterior identity operators. This definition is used because even though an identity operator, I, indicates that the particular qubit at that position will not be used, it still creates a gap between the neighboring Pauli strings. Given that current and near-term quantum computers will predominantly only have neighboring qubit layouts, interior identity operators are not as helpful in term of quantum resource reduction since additional quantum operations have to be performed so the qubits on both sides of the interior identity operators can talk to each other. The VQE search algorithm **300** of the illustrative embodiments seeks to minimize such empty spaces between quantum gates when building the parameterized quantum circuit layer by layer.

As shown in **Figure 4****,** P₀ has a path length of eight because there are no exterior identity operators. In other words, the non-identity operator path takes up the full length of the Pauli string. In the case of P₁, there are two exterior identity operators, one on the left and one on the right, giving P₁ a non-identity operator path length of six. By the same token, both P₂ and P₃ have non-identity operator path length of five. However, the alignment of the exterior identity operators is different for P₂ and P₃. More specifically, P₂ has one left exterior identity operator and two right exterior identity operators, whereas P₃ has all three identity operators to the right. Pauli strings with the same number of exterior identity operators belong to an equivalence class.

Pauli strings within the same equivalence class can further be differentiated according to the lengths of the exterior identity operator paths (how many identity operators are on either side of the non-identity operators). There are only two possible paths, left and right. Therefore, search algorithm **300** is looking for: ${P}_{k} ∈ {S}^{optimal}$ such that $max \left(L, R\right) \geq max \left({L}_{i}, {R}_{i}\right)$ where *L,R* correspond to the left and right exterior identity path length of *Pₖ*, respectively, and *Lᵢ,Rᵢ* correspond to the left and right exterior identity path length of the other Pauli string *Pᵢ* in the class *S^{optimal}.*

Therefore, in the example in **Figure 4****,** P₃ has a max right exterior identity operator path length of three, whereas P₂ has a max right exterior identity operator path length of two. Therefore, P₃ is prioritized or has a higher rank than P₂ even though they both belong to the same equivalence class.

The justification for this process is that even though the circuit construction for all *Pᵢ* ∈ *S^{optimal}* have the same complexity, some offer better flexibility at the next stage/layer of the parameterized quantum circuit compared to others. A longer identity chain offers more flexibility at the next step to select a Pauli string that can be run in parallel with the current Pauli string, thereby providing a way to possibly perform two layers (executing two Pauli strings from the operator pool) with half the coherence time as it would have originally.

Therefore, search algorithm **300** builds the parameterized quantum circuit **304** starting with the Pauli string that has the longest exterior identity path from the largest energy-lowering equivalence class within the set of all equivalence classes of the operator pool, *S*. For the next layer, the algorithm will extend the VQE parameterized quantum circuit by selecting the Pauli string that has the largest overlap between the non-identity operators with identity operators from the previous Pauli string. The selection scheme will go through the equivalence classes in order, with the largest energy-lowering class first. If more than one Pauli string has been found the algorithm will select the one with the longest exterior identity operator path length. The selection of the Pauli string with longest exterior identity operator is critical in the reduction of the overall circuit depth. The process is repeated until convergence is reached or a pre-defined maximum number of layers is reached.

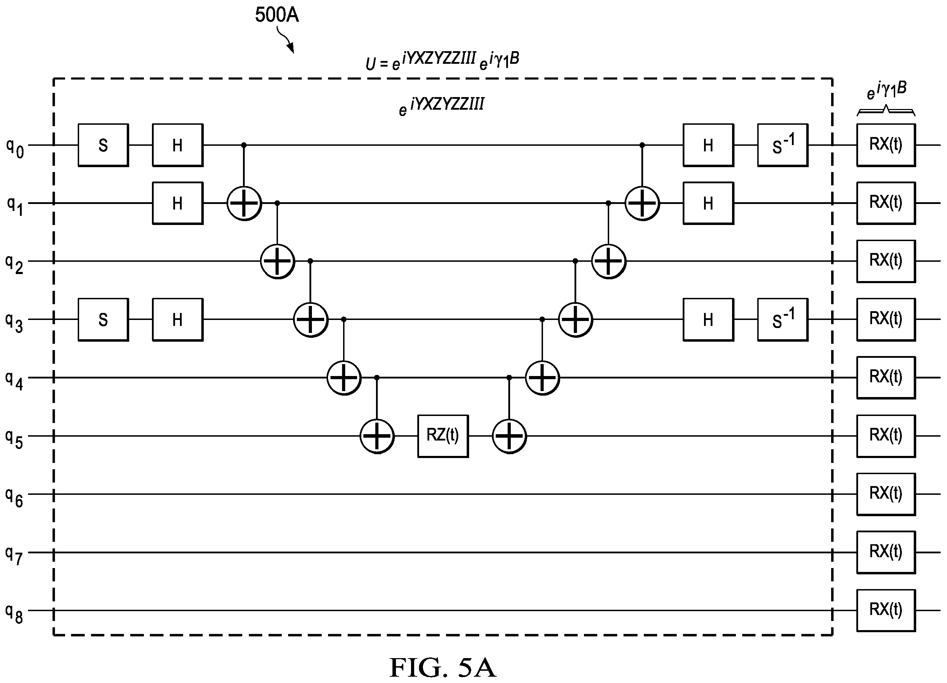

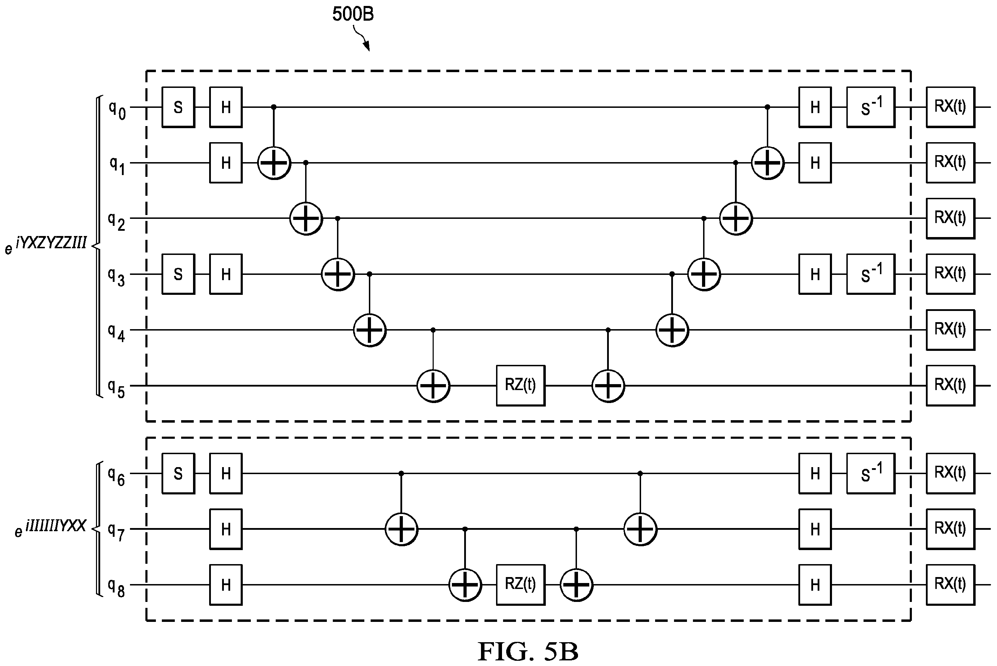

**Figure 5A** depicts an example quantum circuit diagram illustrating a first layer of a parameterized quantum circuit in accordance with an illustrative embodiment. **Figure 5B** depicts the addition of a second layer to the parameterized quantum circuit in **Figure 5A** in accordance with an illustrative embodiment.

In the example shown in **Figure 5A****,** the first layer is built with Pauli string *P*₃ = *YXZYZZIII* **in** **Figure 4****.** In the corresponding quantum circuit **500A,** the left most operator in the Pauli string corresponds to the first qubit, g₀, and the right most operator corresponds to the ninth qubit, q₈. Therefore, because of the three exterior identity operators in the last three positions of P₃, qubits q₆, q₇, and q₈ have no quantum gates.

The goal in building the second layer is to try to improve the result of the first layer with as little required additional coherence time as possible while extending the parameterized quantum circuit in the energy-minimum direction. This goal can be accomplished if the circuits of layer 1 and layer 2 can be performed in parallel or almost parallel.

In the present example, the Pauli string P₃ used for the first layer has non-identity operators in the first six positions of the string. Therefore, for the second layer, the goal is to find Pauli strings with identity operators in the first six positions of the string if possible. If not, the next largest possible overlap is used. These Pauli strings are saved into a temporary set, *S^{temp}*, where the search algorithm will determine the best one based on the optimal exterior identity operator path along with their energy-lowering order based on the order of the equivalence class they belong to in the initial ranking. In the present example, the best Pauli string may be in a form such as *P = IIIIIIYXX,* which when added as the second layer of the parameterized quantum circuit adds quantum gates to qubits q₆-q₈ (which were left open by the first layer), thereby producing quantum circuit **500B** shown in **Figure 5B****.**

Quantum circuit **500B** contains two layers but requires no additional time to execute compared to quantum circuit **500A,** which contains only the first layer. The driving Hamiltonian only needs to be applied once since ${U}_{3} \left({θ}_{1}, {∅}_{1}, {gamma}_{1}\right) ∗ {U}_{3} \left({θ}_{2}, {∅}_{2}, {gamma}_{2}\right) = {U}_{3} \left(θ, ∅, gamma\right)$

As such, it is preferrable to pick a Pauli string with a high exterior identity operator path length in the previous layer if one is available. If the exterior identity operator path length is minimal (i.e., one or less), this step can be skipped or use can be made of the highest *interior* identity operator path to fit in another layer.

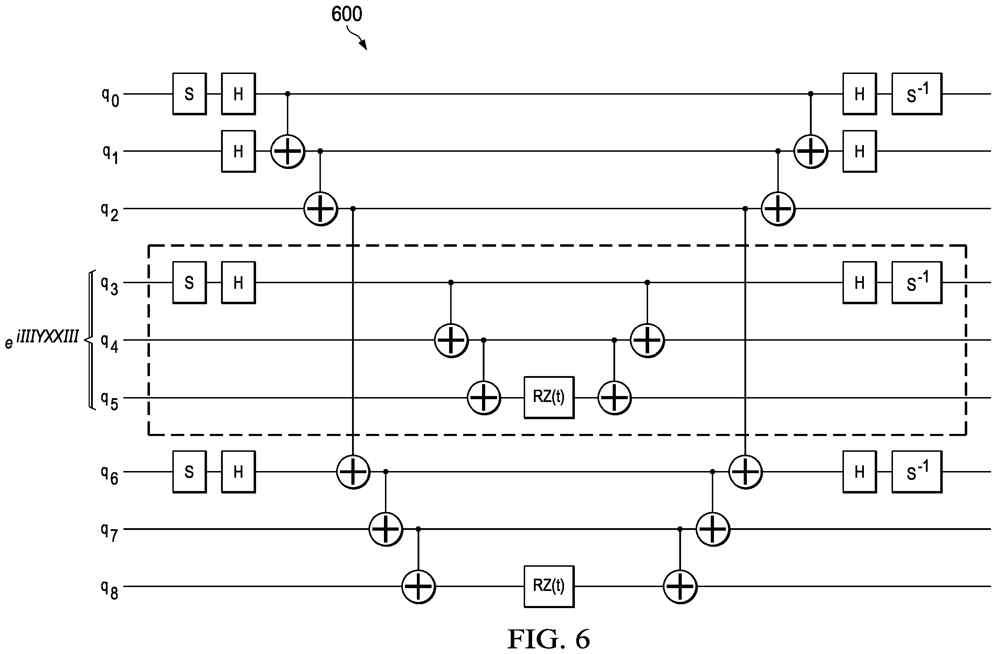

**Figure 6** depicts another example quantum circuit diagram illustrating the first two layers of a parameterized quantum circuit in accordance with an illustrative embodiment. **Figure 6** illustrates an example of using *interior* identity operator path length to optimize a parameterized quantum circuit.

In the present example, the first layer of quantum circuit **600** is based on the Pauli string *P*₁ = *YXZIIIYZZ.* The Pauli string selected for the second layer is selected to take advantage of the space left by the interior identity operators of the first layer. In the present example, the second layer is based on the Pauli string *P*₂ *= IIIYXXIII.* Therefore, quantum gates based on the non-identity operators in the middle of *P*₂ are able to occupy qubits q₃-q₅ left open by the first layer, as shown in quantum circuit **600.**

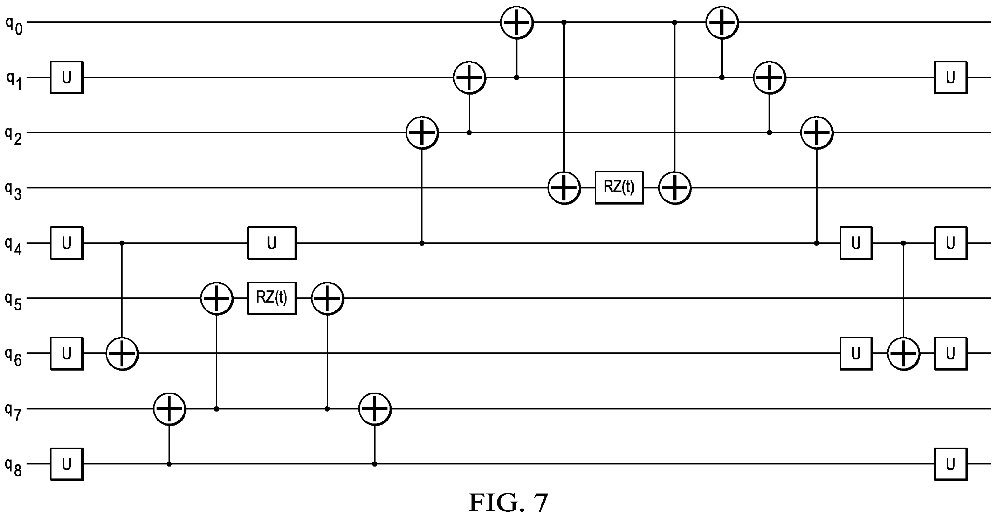

In quantum circuit **600** the entanglement gate between q₂ and q₆ is a long-range two-qubit interaction, which typically would require a significant amount of swapping overhead. However, because quantum circuit **600** comprises a series of CNOT gates in between q₂ and q₆, many terms can be combined to create a shorter circuit as shown in **Figure 7****,** which depicts a transpiled quantum circuit based on quantum circuit **600.**

After the parameterized quantum circuit has been extended by adding the second layer using the optimal Pauli string, the iterative layers will be added using the same logic as the first and second layer as discussed. The process continues until convergence is reached, meaning no further reduction in energy, or until a predefined maximum number of circuit layers is reached.

In order to reduce and improve the ranking of the operators within the operator pool, which consequently will improve the VQE result along with minimizing the execution time, certain chemical properties can be used during the initial ranking to filter out certain Pauli strings or to lower its priority during the parameterized quantum circuit expansion construction process. In particular, total angular momentum or spin can be used because the ground state wave function, the state to be generated with the parameterized quantum circuit, has certain desired chemical properties such as zero total angular momentum and spin.

When searching and building the parameterized quantum circuit to represent the approximate ground state wave function, the parameterized quantum circuit should conserve certain properties like total angular momentum, spin, and total angular momentum. These properties are computed efficiently as expectation values of suitable qubit operators. The conservation of these properties is crucial when the energy gap between the ground state and the first few excited states is small since in such cases VQE will easily converge into a suboptimal solution. However, additional constraint can prevent this from happening. Such constraint may be classified as a "soft constraint" or "hard constraint."

Soft constraint refers to selecting the optimal Pauli strings corresponding to their energy output in addition to their total angular momentum output. Thus, a Pauli string that can generate a low energy is not necessarily the best since it could have high total angular momentum.

For example, a hard constraint can be implemented as adding the total angular momentum operator into the cost function as a penalty term. In this case, $C \left(θ\right) = \left〈ψ\left(θ\right)\right| H \left|ψ\left(θ\right)\right〉$ becomes $C \left(θ\right) = \left〈ψ\left(θ\right)\right| H + {αS}^{2} \left|ψ\left(θ\right)\right〉 α ∈ ℝ$

A large value for *α* will ensure the conservation of total angular momentum in the parameterized quantum circuit wave function.

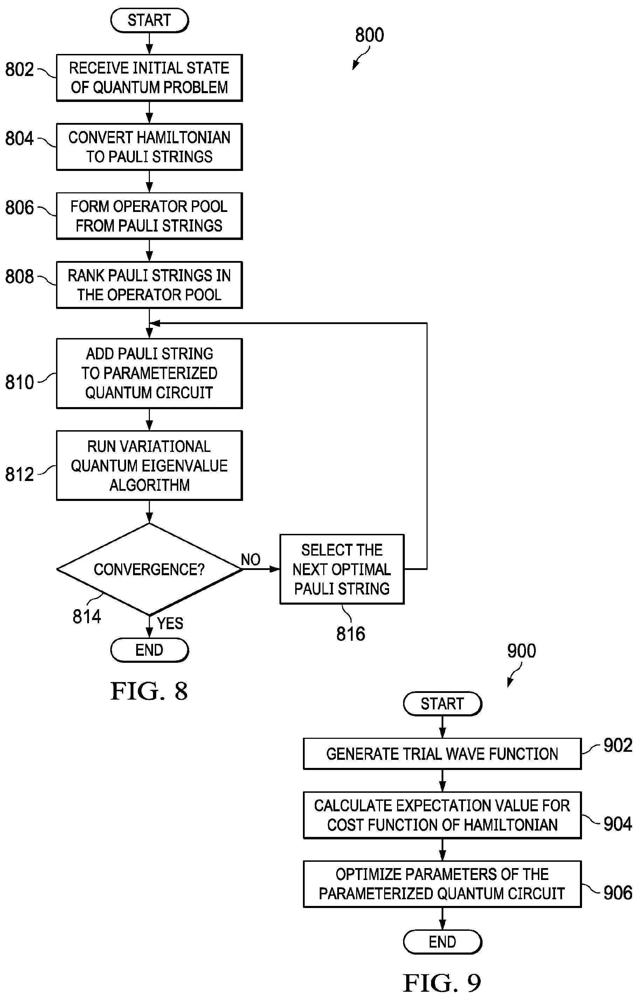

**Figure 8** depicts a flow diagram illustrating a process of minimizing a cost function of a quantum computation in accordance with an illustrative embodiment. Process flow 800 may be implemented in quantum circuit modeling system **200** shown in **Figure 2****.**

Process **800** begins by receiving input of an initial state of a quantum problem instance comprising a Hamiltonian with an associated cost function (operation **802).**

Process **800** converts the Hamiltonian into a number of Pauli strings (operation **804)** and forms an operator pool from the Pauli strings (operation **806).**

The Pauli strings in the operator pool are ranked according to how much they lower a value of cost function with respect to the initial state, e.g., a mean-field state like Hartree-Fock state (operation **808).** The Pauli strings in the operator pool may be further ranked according to non-identity operator path length. Pauli strings with the same non-identity operator path length may be grouped within a same equivalence class. Pauli strings within the same equivalence class may be further ranked according to maximum exterior identity path length.

Process **800** iteratively adds Pauli strings from the operator pool to a parameterized quantum circuit, in a manner to minimize circuit depth, until a VQE algorithm converges to an approximate ground state wave function generated by the parameterized quantum circuit (signifying ground state energy). Quantum gates in the parameterized quantum circuit correspond to non-identity operators in the Pauli strings. The iteration comprises adding a Pauli string from the operator pool to the parameterized quantum circuit according to rank (operation **810).** After a Pauli string from the operator pool is added to the parameterized quantum circuit it is discarded from the operator pool and not used again in future iterations.

The VQE algorithm is then run (operation **812)** to determine if it has reached convergence (operation **814).** Responsive to a determination that the VQE algorithm has not reached convergence, process **800** selected another Pauli string from the operator pool to add to the parameterized quantum circuit (operation **816).** The new Pauli string added to the parameterized quantum circuit from the operator pool is selected to maximize overlap of identity operators in the new Pauli string with non-identity operators in the last added Pauli string and maximize overlap of non-identity operators in the new Pauli string with identity operators in the last added Pauli string.

Operations **810** through **816** are repeated iteratively until the VQE algorithm reaches convergence or no Pauli strings remain in the operator pool. When the quantum circuit reaches convergence the iteration of steps **810-816** stops. The VQE algorithm output corresponding to convergence is taken as ground state energy. Process **800** then ends.

**Figure 9** depicts a flow diagram illustrating a process flow for the VQE algorithm in accordance with an illustrative embodiment. Process flow **900** is a more detailed view of operation **812 in** **Figure 8****.**

Process **900** begins by generating a trial wave function by the parameterized quantum circuit (operation **902),** which is used to calculate an expectation value for the cost function (operation **904).**

A classical optimizer then optimizes a number of parameters of the parameterized quantum circuit (operation **906).** Optimal parameters correspond to values that generate the minimal value of the cost function. Process **900** then ends.

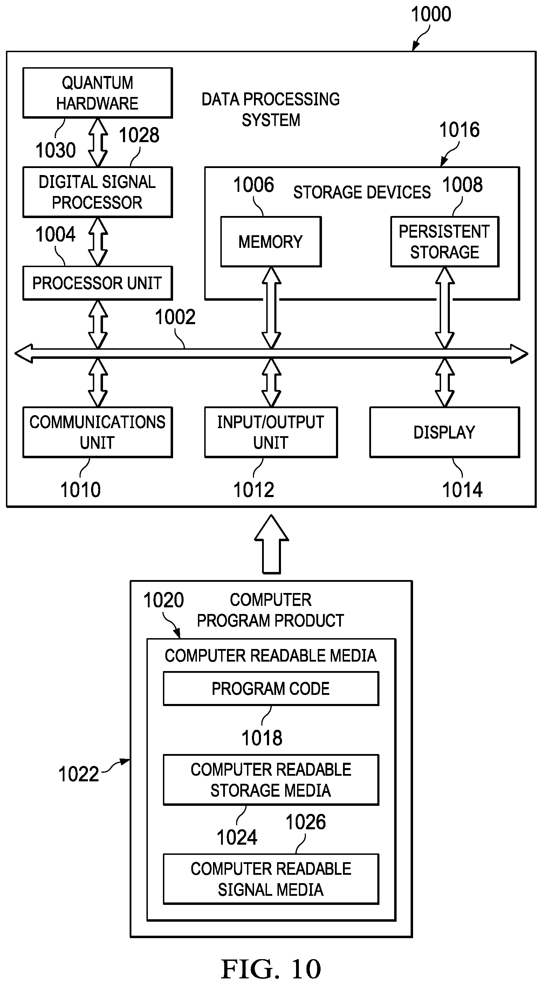

Turning now to **Figure 10****,** an illustration of a block diagram of a data processing system is depicted in accordance with an illustrative embodiment. Data processing system might be an example of computer system **250** in **Figure 2****.** Data processing system **1000** might be used to implement VQE search algorithm **300** in **Figure 3** and process **800** in **Figure 8****.** In this illustrative example, data processing system **1000** includes communications framework **1002,** which provides communications between processor unit **1004,** memory **1006,** persistent storage **1008,** communications unit **1010,** input/output unit **1012,** and display **1014.** In this example, communications framework **1002** may take the form of a bus system.

Processor unit **1004** serves to execute instructions for software that may be loaded into memory **1006.** Processor unit **1004** may be a number of processors, a multi-processor core, or some other type of processor, depending on the particular implementation. In an embodiment, processor unit **1004** comprises one or more conventional general-purpose central processing units (CPUs). Processor unit **1004** may send instructions to and from digital signal processor (DSP) **1028.** DSP **1028** in turn sends analog or hybrid signals to and from quantum hardware **1030.**

Quantum hardware **1030** may comprise quantum circuits based on qubits (quantum bits). Qubits are traditionally used to simulate a 1 or 0 state, or in a superposition of the 1 and 0 states. However, when measured, the qubit may be in an infinite number of states depending on the qubit's quantum state immediately prior to measurement when using a Bloch sphere representation. The quantum circuits may comprise arbitrary single and two qubit gates that form a universal set with respect to the particular quantum computer in used.

Memory **1006** and persistent storage **1008** are examples of storage devices **1016.** A storage device is any piece of hardware that is capable of storing information, such as, for example, without limitation, at least one of data, program code in functional form, or other suitable information either on a temporary basis, a permanent basis, or both on a temporary basis and a permanent basis. Storage devices **1016** may also be referred to as computer-readable storage devices in these illustrative examples. Memory **1006,** in these examples, may be, for example, a random access memory or any other suitable volatile or non-volatile storage device. Persistent storage **1008** may take various forms, depending on the particular implementation.

For example, persistent storage **1008** may contain one or more components or devices. For example, persistent storage **1008** may be a hard drive, a flash memory, a rewritable optical disk, a rewritable magnetic tape, or some combination of the above. The media used by persistent storage **1008** also may be removable. For example, a removable hard drive may be used for persistent storage **1008.** Communications unit **1010,** in these illustrative examples, provides for communications with other data processing systems or devices. In these illustrative examples, communications unit **1010** is a network interface card.

Input/output unit **1012** allows for input and output of data with other devices that may be connected to data processing system **1000.** For example, input/output unit **1012** may provide a connection for user input through at least one of a keyboard, a mouse, or some other suitable input device. Further, input/output unit **1012** may send output to a printer. Display **1014** provides a mechanism to display information to a user.

Instructions for at least one of the operating system, applications, or programs may be located in storage devices **1016,** which are in communication with processor unit **1004** through communications framework **1002.** The processes of the different embodiments may be performed by processor unit **1004** using computer-implemented instructions, which may be located in a memory, such as memory **1006.**

These instructions are referred to as program code, computer-usable program code, or computer-readable program code that may be read and executed by a processor in processor unit **1004.** The program code in the different embodiments may be embodied on different physical or computer-readable storage media, such as memory **1006** or persistent storage **1008.**

Program code **1018** is located in a functional form on computer-readable media **1020** that is selectively removable and may be loaded onto or transferred to data processing system **1000** for execution by processor unit **1004.** Program code **1018** and computer-readable media **1020** form computer program product **1022** in these illustrative examples. Computer program product **1022** might be for aligning reference frames for an augmented reality (AR) display. In one example, computer-readable media **1020** may be computer-readable storage media **1024** or computer-readable signal media **1026.**

In these illustrative examples, computer-readable storage media **1024** is a physical or tangible storage device used to store program code **1018** rather than a medium that propagates or transmits program code **1018.** Alternatively, program code **1018** may be transferred to data processing system **1000** using computer-readable signal media **1026.**

Computer-readable signal media **1026** may be, for example, a propagated data signal containing program code **1018.** For example, computer-readable signal media **1026** may be at least one of an electromagnetic signal, an optical signal, or any other suitable type of signal. These signals may be transmitted over at least one of communications links, such as wireless communications links, optical fiber cable, coaxial cable, a wire, or any other suitable type of communications link.

The different components illustrated for data processing system **1000** are not meant to provide architectural limitations to the manner in which different embodiments may be implemented. The different illustrative embodiments may be implemented in a data processing system including components in addition to or in place of those illustrated for data processing system 1000. Other components shown in Figure 10 can be varied from the illustrative examples shown. The different embodiments may be implemented using any hardware device or system capable of running program code 1018.

As used herein, a first component "connected to" a second component means that the first component can be connected directly or indirectly to the second component. In other words, additional components may be present between the first component and the second component. The first component is considered to be indirectly connected to the second component when one or more additional components are present between the two components. When the first component is directly connected to the second component, no additional components are present between the two components.

As used herein, the phrase "a number" means one or more. The phrase "at least one of", when used with a list of items, means different combinations of one or more of the listed items may be used, and only one of each item in the list may be needed. In other words, "at least one of" means any combination of items and number of items may be used from the list, but not all of the items in the list are required. The item may be a particular object, a thing, or a category.

For example, without limitation, "at least one of item A, item B, or item C" may include item A, item A and item B, or item C. This example also may include item A, item B, and item C or item B and item C. Of course, any combinations of these items may be present. In some illustrative examples, "at least one of" may be, for example, without limitation, two of item A; one of item B; and ten of item C; four of item B and seven of item C; or other suitable combinations.

The flowcharts and block diagrams in the different depicted embodiments illustrate the architecture, functionality, and operation of some possible implementations of apparatuses and methods in an illustrative embodiment. In this regard, each block in the flowcharts or block diagrams may represent at least one of a module, a segment, a function, or a portion of an operation or step. For example, one or more of the blocks may be implemented as program code.

In some alternative implementations of an illustrative embodiment, the function or functions noted in the blocks may occur out of the order noted in the figures. For example, in some cases, two blocks shown in succession may be performed substantially concurrently, or the blocks may sometimes be performed in the reverse order, depending upon the functionality involved. Also, other blocks may be added in addition to the illustrated blocks in a flowchart or block diagram.

The description of the different illustrative embodiments has been presented for purposes of illustration and description and is not intended to be exhaustive or limited to the embodiments in the form disclosed. Many modifications and variations will be apparent to those of ordinary skill in the art. Further, different illustrative embodiments may provide different features as compared to other illustrative embodiments. The embodiment or embodiments selected are chosen and described in order to best explain the principles of the embodiments, the practical application, and to enable others of ordinary skill in the art to understand the disclosure for various embodiments with various modifications as are suited to the particular use contemplated.

## Claims

1. A computer-implemented method (800) of minimizing a cost function of a quantum computation, the method comprising:
using a number of processors to perform the steps of:
receiving (802) input of an initial state (202) of a quantum problem instance comprising a Hamiltonian (204) with an associated cost function (238);
converting (804) the Hamiltonian into a number of Pauli strings (208);
forming (806) an operator pool (206) from the Pauli strings;
ranking (808) the Pauli strings in the operator pool according to how much they lower a value of the cost function with respect to the initial state, wherein the Pauli strings in the operator pool are further ranked according to a non-identity operator path length (218), wherein Pauli strings with the same non-identity operator path length are grouped within a same equivalence class, wherein Pauli strings within the same equivalence class are ranked according to maximum exterior identity path length (220); and
iteratively adding (810) Pauli strings from the operator pool to a parameterized quantum circuit (224) of a quantum hardware (1030), in a manner to minimize circuit depth (234), until a variational quantum eigensolver, VQE, algorithm converges to an approximate ground state wave function generated by the parameterized quantum circuit;
wherein a new Pauli string added to the parameterized quantum circuit from the operator pool is selected to:
maximize overlap of identity operators (214) in the new Pauli string with non-identity operators (216) in the last added Pauli string; and
maximize overlap of non-identity operators in the new Pauli string with identity operators in the last added Pauli string; and
wherein determining whether or not the VQE algorithm has reached convergence comprises:
generating (902), by executing the parameterized quantum circuit on the quantum hardware, a trial wave function (236);
calculating (904) an expectation value (240) for the cost function based on the trial wave function; and
optimizing (906), by a classical optimizer, a number of parameters of the parameterized quantum circuit, wherein optimal parameters correspond to values that generate a minimal value of the cost function.

2. The method of claim 1, wherein iteratively adding Pauli strings from the operator pool to the parameterized quantum circuit comprises:
adding a Pauli string (810) from the operator pool to the parameterized quantum circuit according to rank;
running the VQE algorithm (812) with the parameterized quantum circuit to determine if the VQE algorithm has reached convergence (814);
responsive to a determination that the VQE algorithm has not reached convergence, adding another Pauli string (816) from the operator pool to the parameterized quantum circuit; and
responsive to a determination that the VQE algorithm has reached convergence or no Pauli strings remain in the operator pool, stopping iteration.

3. The method of any one of claims 1 - 2, wherein after a Pauli string from the operator pool is added to the parameterized quantum circuit it is discarded from the operator pool and not used again in future iterations.

4. The method of any one of claims 1 - 3, wherein quantum gates (232) in the parameterized quantum circuit correspond to non-identity operators in the Pauli strings.

5. A system (200) for minimizing a cost function of a quantum computation, the system comprising:
a storage device (1016) configured to store program instructions;
a quantum hardware (1030); and
one or more processors (1004) operably connected to the storage device and configured to execute the program instructions to cause the system to:
receive (802) input of an initial state (202) of a quantum problem instance comprising a Hamiltonian (204) with an associated cost function (238);
convert (804) the Hamiltonian into a number of Pauli strings (208);
form (806) an operator pool (206) from the Pauli strings;
rank (808) the Pauli strings in the operator pool according to how much they lower a value of the cost function with respect to the initial state, wherein the Pauli strings in the operator pool are further ranked according to a non-identity operator path length (218), wherein Pauli strings with the same non-identity operator path length are grouped within a same equivalence class, wherein Pauli strings within the same equivalence class are ranked according to maximum exterior identity path length (220); and
iteratively add (810) Pauli strings from the operator pool to a parameterized quantum circuit (224) of the quantum hardware (1030), in a manner to minimize circuit depth (234), until a variational quantum eigensolver, VQE, algorithm converges to an approximate ground state wave function generated by the parameterized quantum circuit;
wherein a new Pauli string added to the parameterized quantum circuit from the operator pool is selected to:
maximize overlap of identity operators (214) in the new Pauli string with non-identity operators (216) in the last added Pauli string; and
maximize overlap of non-identity operators in the new Pauli string with identity operators in the last added Pauli string; and
wherein determining whether or not the VQE algorithm has reached convergence comprises:
generating (902), by executing the parameterized quantum circuit on the quantum hardware, a trial wave function (236);
calculating (904) an expectation value (240) for the cost function based on the trial wave function; and
optimizing (906), by a classical optimizer, a number of parameters of the parameterized quantum circuit, wherein optimal parameters correspond to values that generate a minimal value of the cost function.

6. The system of claim 5, wherein the one or more processors (1004) are further configured to execute the program instructions to cause the system to iteratively add Pauli strings from the operator pool to the parameterized quantum circuit comprising to cause the system to:
add a Pauli string (810) from the operator pool to the parameterized quantum circuit according to rank;
run the VQE algorithm (812) with the parameterized quantum circuit to determine if the VQE algorithm has reached convergence;
responsive to a determination that the VQE algorithm has not reached convergence, add another Pauli string (816) from the operator pool to the parameterized quantum circuit; and
responsive to a determination that the VQE algorithm has reached convergence or no Pauli strings remain in the operator pool, stop iteration.

## Patentansprüche

1. Computerimplementiertes Verfahren (800) zur Minimierung einer Kostenfunktion einer Quantenberechnung, das Verfahren umfassend:
unter Verwendung einer Anzahl von Prozessoren zur Durchführung der folgenden Schritte:
Empfangen (802) einer Eingabe eines Anfangszustands (202) einer Quantenprobleminstanz, die einen Hamiltonoperator (204) mit einer zugehörigen Kostenfunktion (238) umfasst;
Umwandeln (804) des Hamiltonoperators in eine Anzahl von Pauli-Strings (208);
Bilden (806) eines Operator-Pools (206) aus den Pauli-Strings;
Einstufen (808) der Pauli-Strings in dem Operator-Pool danach, um wie viel sie einen Wert der Kostenfunktion in Bezug auf den Anfangszustand verringern, wobei die Pauli-Strings in dem Operator-Pool weiter gemäß einer Nichtidentitätsoperator-Pfadlänge (218) eingestuft werden, wobei Pauli-Strings mit derselben Nichtidentitätsoperator-Pfadlänge innerhalb derselben Äquivalenzklasse gruppiert werden, wobei Pauli-Strings innerhalb derselben Äquivalenzklasse gemäß maximaler äußerer Identitäts-Pfadlänge (220) eingestuft werden; und
iteratives Hinzufügen (810) von Pauli-Strings aus dem Operator-Pool zu einer parametrisierten Quantenschaltung (224) einer Quantenhardware (1030) in einer Weise zum Minimieren der Schaltungstiefe (234), bis ein variationaler Quanten-Eigensolver-, VQE-, Algorithmus zu einer ungefähren Grundzustandswellenfunktion konvergiert, die durch die parametrisierte Quantenschaltung erzeugt wird;
wobei ein neuer Pauli-String, der aus dem Operator-Pool zu der parametrisierten Quantenschaltung hinzugefügt wird, ausgewählt wird, um:
eine Überlappung von Identitätsoperatoren (214) in dem neuen Pauli-String mit Nichtidentitätsoperatoren (216) in dem zuletzt hinzugefügten Pauli-String zu maximieren; und
eine Überlappung von Nichtidentitätsoperatoren in dem neuen Pauli-String mit Identitätsoperatoren in dem zuletzt hinzugefügten Pauli-String zu maximieren; und
wobei das Bestimmen, ob der VQE-Algorithmus Konvergenz erreicht hat oder nicht, umfasst:
Erzeugen (902) einer Testwellenfunktion (236) durch Ausführen der parametrisierten Quantenschaltung auf der Quantenhardware;
Berechnen (904) eines Erwartungswerts (240) für die Kostenfunktion basierend auf der Testwellenfunktion; und
Optimieren (906) einer Anzahl von Parametern der parametrisierten Quantenschaltung durch einen klassischen Optimierer, wobei optimale Parameter Werten entsprechen, die einen minimalen Wert der Kostenfunktion erzeugen.

2. Verfahren nach Anspruch 1, wobei das iterative Hinzufügen von Pauli-Strings aus dem Operator-Pool zu der parametrisierten Quantenschaltung umfasst:
Hinzufügen eines Pauli-Strings (810) aus dem Operator-Pool zu der parametrisierten Quantenschaltung gemäß Einstufung;
Ausführen des VQE-Algorithmus (812) mit der parametrisierten Quantenschaltung, um zu bestimmen, ob der VQE-Algorithmus Konvergenz erreicht hat (814);
als Reaktion auf eine Feststellung, dass der VQE-Algorithmus keine Konvergenz erreicht hat, Hinzufügen eines weiteren Pauli-Strings (816) aus dem Operator-Pool zu der parametrisierten Quantenschaltung; und
als Reaktion auf eine Feststellung, dass der VQE-Algorithmus Konvergenz erreicht hat oder keine Pauli-Strings in dem Operator-Pool verbleiben, Stoppen der Iteration.

3. Verfahren nach einem der Ansprüche 1-2, wobei, nachdem ein Pauli-String aus dem Operator-Pool zu der parametrisierten Quantenschaltung hinzugefügt wird, er aus dem Operator-Pool verworfen und in zukünftigen Iterationen nicht wiederverwendet wird.

4. Verfahren nach einem der Ansprüche 1-3, wobei Quantengatter (232) in der parametrisierten Quantenschaltung Nichtidentitätsoperatoren in den Pauli-Strings entsprechen.

5. System (200) zur Minimierung einer Kostenfunktion einer Quantenberechnung, das System umfassend:
eine Speichervorrichtung (1016), ausgebildet zum Speichern von Programmanweisungen;
eine Quantenhardware (1030); und
ein oder mehrere Prozessoren (1004), die funktionsfähig mit der Speichervorrichtung verbunden und ausgebildet sind, die Programmanweisungen auszuführen, um das System zu veranlassen:
eine Eingabe (802) eines Anfangszustands (202) einer Quantenprobleminstanz zu empfangen, die einen Hamiltonoperator (204) mit einer zugehörigen Kostenfunktion (238) umfasst;
den Hamiltonoperator in eine Anzahl von Pauli-Strings (208) umzuwandeln (804);
einen Operator-Pool (206) aus den Pauli-Strings zu bilden (806);
die Pauli-Strings in dem Operator-Pool danach einzustufen (808), um wie viel sie einen Wert der Kostenfunktion in Bezug auf den Anfangszustand verringern, wobei die Pauli-Strings in dem Operator-Pool weiter gemäß einer Nichtidentitätsoperator-Pfadlänge (218) eingestuft werden, wobei Pauli-Strings mit derselben Nichtidentitätsoperator-Pfadlänge innerhalb derselben Äquivalenzklasse gruppiert werden, wobei Pauli-Strings innerhalb derselben Äquivalenzklasse gemäß maximaler äußerer Identitäts-Pfadlänge (220) eingestuft werden; und
Pauli-Strings (810) aus dem Operator-Pool zu einer parametrisierten Quantenschaltung (224) der Quantenhardware (1030) iterativ hinzuzufügen, in einer Weise zum Minimieren der Schaltungstiefe (234), bis ein variationaler Quanten-Eigensolver-, VQE-, Algorithmus zu einer ungefähren Grundzustandswellenfunktion konvergiert, die durch die parametrisierte Quantenschaltung erzeugt wird;
wobei ein neuer Pauli-String, der aus dem Operator-Pool zu der parametrisierten Quantenschaltung hinzugefügt wird, ausgewählt wird, um:
eine Überlappung von Identitätsoperatoren (214) in dem neuen Pauli-String mit Nichtidentitätsoperatoren (216) in dem zuletzt hinzugefügten Pauli-String zu maximieren; und
eine Überlappung von Nichtidentitätsoperatoren in dem neuen Pauli-String mit Identitätsoperatoren in dem zuletzt hinzugefügten Pauli-String zu maximieren; und
wobei das Bestimmen, ob der VQE-Algorithmus Konvergenz erreicht hat oder nicht, umfasst:
Erzeugen (902) einer Testwellenfunktion (236) durch Ausführen der parametrisierten Quantenschaltung auf der Quantenhardware;
Berechnen (904) eines Erwartungswerts (240) für die Kostenfunktion basierend auf der Testwellenfunktion; und
Optimieren (906) einer Anzahl von Parametern der parametrisierten Quantenschaltung durch einen klassischen Optimierer, wobei optimale Parameter Werten entsprechen, die einen minimalen Wert der Kostenfunktion erzeugen.

6. System nach Anspruch 5, wobei die ein oder mehrere Prozessoren (1004) weiter ausgebildet sind, die Programmanweisungen auszuführen, um zu bewirken, dass das System Pauli-Strings aus dem Operator-Pool iterativ zu der parametrisierten Quantenschaltung hinzufügt, umfassend zu bewirken, dass das System:
einen Pauli-String (810) aus dem Operator-Pool zu der parametrisierten Quantenschaltung gemäß Einstufung hinzuzufügen;
den VQE-Algorithmus (812) mit der parametrisierten Quantenschaltung auszuführen, um zu bestimmen, ob der VQE-Algorithmus Konvergenz erreicht hat;
als Reaktion auf eine Feststellung, dass der VQE-Algorithmus keine Konvergenz erreicht hat, einen weiteren Pauli-String (816) aus dem Operator-Pool zu der parametrisierten Quantenschaltung hinzuzufügen; und
als Reaktion auf eine Feststellung, dass der VQE-Algorithmus Konvergenz erreicht hat oder keine Pauli-Strings in dem Operator-Pool verbleiben, die Iteration zu stoppen.

## Revendications

1. Procédé mis en œuvre par ordinateur (800) de minimisation d'une fonction de coût d'un calcul quantique, le procédé comprenant :
l'utilisation d'un nombre de processeurs pour effectuer les étapes consistant à :
recevoir (802) une entrée d'un état initial (202) d'une instance de problème quantique comprenant un hamiltonien (204) avec une fonction de coût associée (238) ;
convertir (804) l'hamiltonien en un nombre de chaînes de Pauli (208) ;
former (806) un ensemble d'opérateurs (206) à partir des chaînes de Pauli ;
ranger (808) les chaînes de Pauli dans l'ensemble d'opérateurs selon dans quelle mesure elles abaissent une valeur de la fonction de coût par rapport à l'état initial, dans lequel les chaînes de Pauli dans l'ensemble d'opérateurs sont en outre rangées selon une longueur de chemin des opérateurs non identité (218), dans lequel des chaînes de Pauli présentant la même longueur de chemin des opérateurs non identité sont groupées au sein d'une même classe d'équivalence, dans lequel les chaînes de Pauli au sein de la même classe d'équivalence sont rangées selon une longueur de chemin maximale d'identité extérieure (220) ; et
ajouter de manière itérative (810) des chaînes de Pauli provenant de l'ensemble d'opérateurs à un circuit quantique paramétré (224) d'un matériel quantique (1030), de manière à minimiser une profondeur de circuit (234), jusqu'à ce qu'un solveur quantique variationnel de valeurs propres, VQE, converge vers une fonction d'onde d'état fondamental approximative générée par le circuit quantique paramétré ;
dans lequel une nouvelle chaîne de Pauli ajoutée au circuit quantique paramétré depuis l'ensemble d'opérateurs est sélectionnée pour :
maximiser un recouvrement d'opérateurs identité (214) dans la nouvelle chaîne de Pauli avec des opérateurs non identité (216) dans la dernière chaîne de Pauli ajoutée ; et
maximiser un recouvrement d'opérateurs non identité dans la nouvelle chaîne de Pauli avec des opérateurs identité dans la dernière chaîne de Pauli ajoutée ; et
dans lequel déterminer si l'algorithme VQE a ou n'a pas atteint la convergence comprend les étapes consistant à :
générer (902), par exécution du circuit quantique paramétré sur le matériel quantique, une fonction d'onde d'essai (236) ;
calculer (904) une valeur d'espérance (240) pour la fonction de coût sur la base de la fonction d'onde d'essai ; et
optimiser (906), par un optimiseur classique, un nombre de paramètres du circuit quantique paramétré, dans lequel des paramètres optimaux correspondent à des valeurs qui génèrent une valeur minimale de la fonction de coût.

2. Procédé selon la revendication 1, dans lequel ajouter de manière itérative des chaînes de Pauli provenant de l'ensemble d'opérateurs au circuit quantique paramétré comprend les étapes consistant à :
ajouter une chaîne de Pauli (810) provenant de l'ensemble d'opérateurs au circuit quantique paramétré selon le rang ;
faire fonctionner l'algorithme VQE (812) avec le circuit quantique paramétré pour déterminer si l'algorithme VQE a atteint la convergence (814) ;
en réponse à une détermination selon laquelle l'algorithme VQE n'a pas atteint la convergence, ajouter une autre chaîne de Pauli (816) provenant de l'ensemble d'opérateurs au circuit quantique paramétré ; et
en réponse à une détermination selon laquelle l'algorithme VQE a atteint la convergence ou qu'aucune chaîne de Pauli ne reste dans l'ensemble d'opérateurs, arrêter l'itération.

3. Procédé selon l'une quelconque des revendications 1 - 2, dans lequel après qu'une chaîne de Pauli provenant de l'ensemble d'opérateurs est ajoutée au circuit quantique paramétré, elle est écartée de l'ensemble d'opérateurs et n'est pas utilisée de nouveau dans des itérations futures.

4. Procédé selon l'une quelconque des revendications 1 à 3, dans lequel des portes quantiques (232) dans le circuit quantique paramétré correspondent à des opérateurs non identité dans les chaînes de Pauli.

5. Système (200) pour minimiser une fonction de coût d'un calcul quantique, le système comprenant :
un dispositif de stockage (1016) configuré pour stocker des instructions de programme ;
un matériel quantique (1030) ; et
un ou plusieurs processeurs (1004) reliés de manière fonctionnelle au dispositif de stockage et configurés pour exécuter les instructions de programme pour amener le système à :
recevoir (802) une entrée d'un état initial (202) d'une instance de problème quantique comprenant un hamiltonien (204) avec une fonction de coût associée (238) ;
convertir (804) l'hamiltonien en un nombre de chaînes de Pauli (208) ;
former (806) un ensemble d'opérateurs (206) à partir des chaînes de Pauli ;
ranger (808) les chaînes de Pauli dans l'ensemble d'opérateurs selon dans quelle mesure elles abaissent une valeur de la fonction de coût par rapport à l'état initial, dans lequel les chaînes de Pauli dans l'ensemble d'opérateurs sont en outre rangées selon une longueur de chemin des opérateurs non identité (218), dans lequel des chaînes de Pauli présentant la même longueur de chemin des opérateurs non identité sont groupées au sein d'une même classe d'équivalence, dans lequel les chaînes de Pauli au sein de la même classe d'équivalence sont rangées selon une longueur de chemin maximale d'identité extérieure (220) ; et
ajouter de manière itérative (810) des chaînes de Pauli provenant de l'ensemble d'opérateurs à un circuit quantique paramétré (224) du matériel quantique (1030), de manière à minimiser une profondeur de circuit (234), jusqu'à ce qu'un solveur quantique variationnel de valeurs propres, VQE, converge vers une fonction d'onde d'état fondamental approximative générée par le circuit quantique paramétré ;
dans lequel une nouvelle chaîne de Pauli ajoutée au circuit quantique paramétré depuis l'ensemble d'opérateurs est sélectionnée pour :
maximiser un recouvrement d'opérateurs identité (214) dans la nouvelle chaîne de Pauli avec des opérateurs non identité (216) dans la dernière chaîne de Pauli ajoutée ; et
maximiser un recouvrement d'opérateurs non identité dans la nouvelle chaîne de Pauli avec des opérateurs identité dans la dernière chaîne de Pauli ajoutée ; et
dans lequel déterminer si l'algorithme VQE a ou n'a pas atteint la convergence comprend les étapes consistant à :
générer (902), par exécution du circuit quantique paramétré sur le matériel quantique, une fonction d'onde d'essai (236) ;
calculer (904) une valeur d'espérance (240) pour la fonction de coût sur la base de la fonction d'onde d'essai ; et
optimiser (906), par un optimiseur classique, un nombre de paramètres du circuit quantique paramétré, dans lequel des paramètres optimaux correspondent à des valeurs qui génèrent une valeur minimale de la fonction de coût.

6. Système selon la revendication 5, dans lequel un ou plusieurs processeurs (1004) sont en outre configurés pour exécuter les instructions de programme pour amener le système à ajouter de manière itérative des chaînes de Pauli de l'ensemble d'opérateurs au circuit quantique paramétré, comprenant le fait d'amener le système à :
ajouter une chaîne de Pauli (810) provenant de l'ensemble d'opérateurs au circuit quantique paramétré selon le rang ;
faire fonctionner l'algorithme VQE (812) avec le circuit quantique paramétré pour déterminer si l'algorithme VQE a atteint la convergence ;
en réponse à une détermination selon laquelle l'algorithme VQE n'a pas atteint la convergence, ajouter une autre chaîne de Pauli (816) provenant de l'ensemble d'opérateurs au circuit quantique paramétré ; et
en réponse à une détermination selon laquelle l'algorithme VQE a atteint la convergence ou qu'aucune chaîne de Pauli ne reste dans l'ensemble d'opérateurs, arrêter l'itération.
